# FASCICULE DE BREVET EUROPEEN

(11) **EP 4 192 704 B1**
(45) Date de publication et mention de la délivrance du brevet: **03.07.2024**
(21) Numéro de dépôt: 21737423.0
(22) Date de dépôt: 28.06.2021
(51) Int. Cl.: B60L 3/00, B60L 50/61, G01R 31/52, G01R 31/55, G01R 31/00, G01R 31/327, B60W 50/038, B60L 3/08, B60W 20/50, H01H 47/00, B60W 50/02, B60W 50/029

(54) **PROCÉDÉ DE DIAGNOSTIC DE L'OUVERTURE DES RELAIS D'UNE BATTERIE D'UN GROUPE MOTOPROPULSEUR HYBRIDE**
VERFAHREN ZUR DIAGNOSE DER ÖFFNUNG DER RELAIS EINER BATTERIE EINES HYBRIDEN ANTRIEBSSTRANGS
METHOD FOR DIAGNOSING THE OPENING OF THE RELAYS OF A BATTERY OF A HYBRID POWERTRAIN

(30) Priorité: 05.08.2020 FR 2008310
(43) Date de publication de la demande: 14.06.2023
(73) Titulaire: Renault s.a.s, 92100 Boulogne Billancourt (FR); NISSAN MOTOR CO., LTD., Yokohama-shi, Kanagawa 221-0023 (JP)
(72) Inventeur: BAUMANN, Thibaut, 78150 Le Chesnay (FR); BOUARFA, Abdelkader, 78280 Guyancourt (FR)
(74) Mandataire: Renault Group
(86) Numéro de dépôt international: PCT/EP2021/067717
(87) Numéro de publication internationale: WO 2022/028777

(56) Documents cités:
- EP-A1- 1 566 303
- EP-B1- 1 566 303
- FR-A1- 3 024 301
- JP-A- 2000 278 802
- US-A1- 2005 269 981
- US-A1- 2007 221 627

## Description

L'invention a trait au domaine de l'alimentation de réseau de bord de véhicule automobile à une batterie d'accumulateurs, et plus particulièrement au diagnostic de l'état de fonctionnement des relais assurant la coupure et le raccordement bipolaire du réseau électrique à la batterie d'accumulateurs électriques.

Certains véhicules automobiles hybrides comprennent 2 machines électriques, un moteur thermique et une batterie électrique haute-tension.

Pour de tels véhicules, il est connu qu'une première machine électrique est appelée machine électrique primaire, connectée aux roues, tandis qu'une seconde machine électrique peut être employée, soit de manière connectable aux roues via un arbre de transmission généralement lié au boîtier de vitesses, soit pour assurer une assistance électrique, moteur ou en recharge, à la première machine électrique. Une telle architecture est par exemple décrite dans le document FR3053299. Il est à noter que la machine électrique primaire est cependant déconnectable des roues via le boîtier de vitesses par exemple en cas de défaut de la machine électrique primaire.

Dans de tels véhicules hybrides, plusieurs modes d'hybridation sont possibles.

On entend par mode d'hybridation les différents modes de fonctionnement du véhicule automobile pour assurer la traction et la gestion énergétique en fonction des deux machines électriques et du moteur à combustion interne.

On connaît deux familles principales d'hybridation : l'hybridation parallèle, dans laquelle les différentes sources d'énergies sont employées en parallèle pour assurer la traction, et l'hybridation série, dans laquelle le véhicule ne fonctionne que par l'énergie électrique, l'énergie thermique ne venant qu'en soutien du moteur électrique.

L'invention concerne notamment un mode particulier d'une hybridation série, mis en oeuvre notamment en cas de défaillance d'une des batteries haute tension, par exemple une batterie 400 volts, afin d'éviter une panne immobilisante. Dans ce mode, la machine électrique assure seule la traction au démarrage ou à basse vitesse.

En effet, certaines défaillances batterie impliquent l'interdiction de régénérer la batterie, en utilisant l'énergie produite par les moteurs disponibles ou l'inertie. Cette interdiction induit alors la décharge très rapide de la batterie, et une panne immobilisante pour le conducteur, puisque seule la machine électrique peut assurer le démarrage du véhicule automobile.

Dans l'hybridation série et parallèle, le moteur à combustion interne est désactivé en dessous d'une certaine vitesse, notamment parce que la typologie de la boîte de vitesse utilisée, généralement une boîte de vitesse automatique non-synchronisée à crabots, empêche son fonctionnement pour démarrer le véhicule. Aussi, en mode hybride parallèle, un arrêt du véhicule induira l'impossibilité de redémarrer, et en mode hybride série, un arrêt du véhicule, avec arrêt du moteur à combustion interne, induira l'impossibilité de redémarrer.

En outre une décharge du bus haute tension relié à la batterie haute tension implique, en mode parallèle, l'arrêt de la conversion DCDC pour alimenter le réseau de bord, dit réseau 14V, et déclenche des protections des calculateurs sur ce réseau. Ceci ayant pour conséquence de bloquer le fonctionnement correct du véhicule

Ce mode série particulier, utilisé en cas de défaillance batterie, déconnecte la batterie du système de traction, pour éviter de l'endommager, et pour se protéger du risque de feu.

En outre ce mode série déconnecte le moteur à combustion interne des roues et le fait fonctionner en régulation de vitesse.

On procède alors à la régulation de la tension de la capacité de lissage haute tension connectée au bus haute tension, par la machine électrique secondaire, via une structure connue appelée *High-voltage Starter Generator, HSG,* en transformant l'énergie produite de la machine à combustion interne.

Ce mode série, mis en oeuvre dans l'invention permet ainsi de continuer la traction avec la machine électrique principale, connectée aux roues, ainsi que la conversion DCDC, notamment pour alimenter le réseau électrique de bord, à partir de l'énergie disponible sur le bus haute tension dit bus DC, alimenté par la machine électrique secondaire.

Ainsi, lorsque le véhicule est en roulage dans ce mode série, la batterie est déconnectée du système via l'ouverture des relais haute-tension, ici appelés relais HV, ce qui assure la protection vis-à-vis du risque de feu.

L'onduleur générant la tension sur les condensateurs haute tension dits condensateurs DC *(DC capacitors),* du bus DC, il existe le risque d'envoyer de la puissance à la batterie électrique endommagée si les relais venaient à se refermer de manière intempestive.

Or aucune solution de l'art antérieur n'est satisfaisante pour éviter un tel risque. Voir par exemple US2005/269981A1 ou FR3024301A1.

Aussi l'invention vise à trouver une solution pour s'assurer qu'aucune énergie ne puisse être transmise à la batterie haute-tension.

D'une manière plus générale l'invention décrit un procédé, applicable à toute autre situation dans laquelle on doit s'assurer de l'ouverture correcte, et la non-fermeture, des relais haute-tension pour isoler la batterie du bus DC.

A cet effet on propose, un procédé de diagnostic d'un groupe motopropulseur hybride d'un véhicule automobile, comprenant une première machine électrique d'entraînement du véhicule automobile, connectée via un premier onduleur à un bus de tension continue lissé en tension par un organe d'amortissement passif, par exemple un condensateur, le groupe motopropulseur hybride comprenant en outre une seconde machine électrique apte à recevoir l'énergie produite par une machine à combustion interne et à la transmettre audit bus de tension continue, un second onduleur régulant la tension dudit bus de tension continue ; et une batterie d'accumulateurs électrique connecté au bus de tension continue par un relais commandé, pour fournir une tension continue audit bus de tension continue ; le véhicule automobile comprenant un organe de commande du groupe motopropulseur adapté pour mettre en oeuvre les étapes suivantes :
- Commander l'ouverture dudit relais commandé de sorte à isoler la batterie du bus de tension continue ;
- Définir une fonction de tension de diagnostic variable en fonction d'une tension de consigne du bus de tension continue et d'une composante variable périodique ;
- Définir une amplitude de seuil d'éloignement de la tension de diagnostic variable ;
- Commander à l'organe de régulation la régulation du bus de tension continue à ladite tension de diagnostic variable;
- Vérifier, sur une fenêtre glissante d'une durée prédéfinie, si la tension du bus de tension continue suit la tension de diagnostic variable avec un écart inférieur à l'amplitude de seuil définie ;
- Diagnostiquer l'ouverture du relais en fonction des conditions suivantes :
   si sur la durée prédéfinie de ladite fenêtre glissante,
   la tension du bus de tension continue a suivi la tension de diagnostic variable avec un écart inférieur ou égal à l'amplitude de seuil définie, diagnostiquer que ledit relais est ouvert ; et
   si sur la durée prédéfinie de ladite fenêtre glissante, la tension du bus de tension s'est écartée de la tension de diagnostic variable d'un écart supérieur à l'amplitude de seuil définie, diagnostiquer que ledit relais n'est pas correctement ouvert.

Ainsi, l'invention permet de diagnostiquer la bonne ouverture du relais isolant la batterie, de manière relativement robuste et sans qu'il ne soit nécessaire de mesurer la tension de la batterie et sans qu'il ne soit nécessaire d'ajouter de capteur ou de matériel complémentaire.

En outre ceci permet de détecter les cas ou le mode de série n'est plus viable à cause d'une régulation non fonctionnelle, par exemple lors de :
- un dépassement de la puissance maximale que peut fournir le *HSG* entraîné par le moteur à combustion interne
- un défaut quelconque impactant la régulation des courants du *HSG*

Avantageusement et de manière non limitative, on procède, après l'étape de commande d'ouverture dudit relais, à une étape d'attente d'une durée prédéterminée, avant de mettre en oeuvre l'étape de commande à l'organe de régulation. Ainsi, on laisse du temps au relais de procéder à l'ouverture avant de commencer le diagnostic, ce qui permet de s'assurer de ne pas faire d'erreur de détection.

En particulier, ladite durée prédéterminée d'attente correspond à une durée maximale d'ouverture dudit relais. Ce qui bien que plus long, permet de ne commencer le diagnostic que lorsque le relais est supposé avoir terminé de s'ouvrir.

Avantageusement et de manière non limitative, au cours de l'étape de diagnostic, on diagnostique que ledit relais n'est pas correctement ouvert si, sur la durée prédéfinie la tension du bus de tension s'est écartée de la tension de diagnostic variable d'un écart supérieur à l'amplitude de seuil définie, de manière continue pendant une durée de confirmation prédéterminée. Ainsi, afin d'éviter qu'une déviation transitoire ne déclenche un diagnostic incorrect, on définit une durée de confirmation. Si la tension continue est hors des limites établies pendant une durée inférieure à cette durée de confirmation, on considère alors qu'il ne s'agit pas d'un écart significatif, mais si la tension continue est hors des limites établies pendant une durée supérieure ou égale à cette durée de confirmation, on considère alors qu'il s'agit d'un écart significatif et d'un relais incorrectement ouvert, ou encore d'un problème de régulation NOK.

Avantageusement et de manière non limitative, ladite composante variable période de ladite tension de consigne du bus de tension continue comprend une composante triangulaire ou trapézoïdale ajoutée à une tension continue de régulation. Cette composante triangulaire ou trapézoïdale est particulièrement performante pour effectuer le diagnostic selon l'invention.

En particulier la composante trapézoïdale permet un diagnostique plus rapide et moins impactant pour les autres consommateurs du bus haute-tension.

L'invention concerne aussi un dispositif de diagnostic d'un groupe motopropulseur hybride d'un véhicule automobile, comprenant une première machine électrique d'entraînement du véhicule automobile, connectée via un premier onduleur à un bus de tension continue régulé en tension par un organe de régulation,
le groupe motopropulseur hybride comprenant en outre une seconde machine électrique apte à recevoir l'énergie produite par une machine à combustion interne et à la transmettre via un second onduleur audit bus de tension continue ; et une batterie d'accumulateurs électrique connecté au bus de tension continue par un relais commandé, pour fournir une tension continue audit bus de tension continue, ledit dispositif comprenant :
Des moyens de commande de l'ouverture dudit relais commandé de sorte à isoler la batterie du bus de tension continue ;
Des moyens de définition d'une fonction de tension de diagnostic variable en fonction d'une tension de consigne du bus de tension continue et d'une composante variable périodique ;
Des moyens de définition d'une amplitude de seuil d'éloignement de la tension de diagnostic variable ;
Des moyens de commande de l'organe de régulation pour réguler le bus de tension continue à ladite tension de diagnostic variable ;
Des moyens de vérification, sur une fenêtre glissante d'une durée prédéfinie, si la tension du bus de tension continue suit la tension de diagnostic variable avec un écart inférieur à l'amplitude de seuil définie ;
Des moyens de diagnostic adaptés de sorte que si sur la durée prédéfinie de ladite fenêtre glissante la tension du bus de tension continue a suivi la tension de diagnostic variable avec un écart inférieur ou égal à l'amplitude de seuil définie, on diagnostique que ledit relais est ouvert ; et si au cours de la durée prédéfinie la tension du bus de tension s'est écartée de la tension de diagnostic variable d'un écart supérieur à l'amplitude de seuil définie, on diagnostique que ledit relais n'est pas correctement ouvert.

L'invention concerne aussi un véhicule automobile comprenant un groupe motopropulseur hybride d'un véhicule automobile, comprenant une première machine électrique d'entraînement du véhicule automobile, connectée via un premier onduleur à un bus de tension continue lissé en tension par un organe d'amortissement passif, le groupe motopropulseur hybride comprenant en outre une seconde machine électrique apte à recevoir l'énergie produite par une machine à combustion interne et à la transmettre audit bus de tension continue, un second onduleur régulant en tension ledit bus de tension continue ; et une batterie d'accumulateurs électrique connecté au bus de tension continue par un relais commandé, pour fournir une tension continue audit bus de tension continue, et un dispositif de diagnostic tel que décrit précédemment.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :
[Fig. 1] est une vue schématique d'un groupe motopropulseur hybride mis en oeuvre pour l'invention ;
[Fig. 2] est un organigramme schématique du mode de réalisation principal de l'invention dans lequel les phases vérification et diagnostic sont jouées en continu sur fenêtre glissante ;
[Fig. 3] est un graphique temporel des tensions de diagnostic et de la tension du bus continu, lors du diagnostic d'une ouverture correcte du relais par le procédé selon la figure 2 ;
[Fig. 4] est un graphique temporel des tensions de diagnostic et de la tension du bus continu, lors du diagnostic d'une ouverture incorrecte du relais par le procédé selon la figure 2, ici lorsque s'est produit une refermeture des relais avec une tension batterie très différente de la tension du bus régulée ;
[Fig. 5] est un graphique temporel des tensions de diagnostic et de la tension du bus continu, lors du diagnostic d'une autre ouverture incorrecte du relais par le procédé selon la figure 2, ici lorsque s'est produit une refermeture des relais avec tension batterie très proche de la tension du bus régulée. Dans ce cas, on préfère un profil de régulation en triangle ou trapézoïdal pour détecter une refermeture du relais.

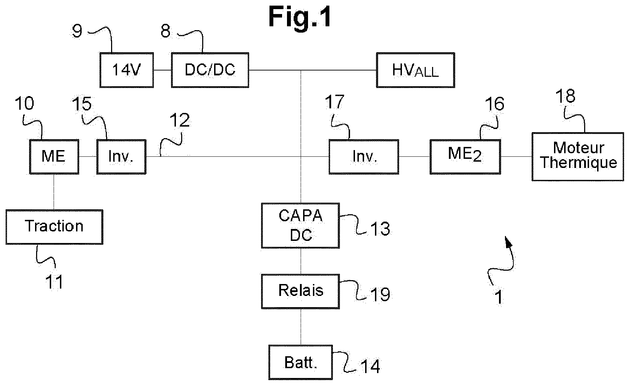

En référence à la figure 1, un véhicule automobile comprend un groupe motopropulseur hybride 1.

Le groupe motopropulseur 1, abrégé GMP 1 comprend d'une part un moteur à combustion interne 18, aussi appelé moteur thermique 18, et deux machines électriques 10, 16.

Dans un mode d'hybridation du GMP 1, mis en oeuvre dans l'invention, une première machine électrique 10 est en prise avec les organes 11 d'entraînement du véhicule automobile.

Cette première machine électrique 10 est associé à un premier onduleur 15 recevant une tension continue d'un bus de tension continue 12.

Ce bus de tension continue 12 est régulé en tension par un organe de régulation de tension 13, ici un ensemble actif dit de capacité DC 13.

Le bus de tension continue 12, aussi abrégé bus DC 12 est aussi connecté à une seconde machine électrique 16, par l'intermédiaire d'un second onduleur 17.

Cette seconde machine électrique 16, est elle-même connectée au moteur thermique 18. Ainsi, la seconde machine électrique 16 est apte à convertir l'énergie produite par le moteur thermique 18 en une tension pouvant être transmise sur le bus DC 12.

Le bus DC 12 est aussi connecté à une batterie d'accumulateurs électriques haute-tension 14, généralement d'une tension de sensiblement 400V, via un relais 19 de protection commandé.

De plus le bus DC 12 est connecté au réseau de bord 9 du véhicule automobile, aussi appelé réseau 14 V par l'intermédiaire d'un convertisseur continu-continu 8, abrégé DC/DC 8.

Selon l'architecture ainsi décrite du mode série, seule la première machine électrique 10 peut entraîner en mouvement le véhicule automobile.

Cette première machine électrique est alimentée soit par la batterie 14 soit par l'énergie électrique transmise par la seconde machine électrique, par transformation de l'énergie produite par le moteur thermique 18.

Or, il existe des cas où il est nécessaire de déconnecter la batterie du bus DC 12. A titre d'exemple, lorsque la batterie 14 présente une défaillance, il est nécessaire de la déconnecter du bus DC 12 afin de s'assurer qu'aucun risque de sécurité ne soit pris.

Aussi, on procède à la déconnexion de la batterie 14 par l'ouverture du relais 19.

Lorsque le relais 19 est ouvert, de sorte que la batterie 14 est déconnectée, on procède alors à l'alimentation de la première machine électrique 10, via la fourniture d'électricité par la seconde machine électrique 16, convertissant l'énergie fournie par le moteur thermique 18.

Toutefois, si le relais 19 n'était accidentellement pas correctement ouvert, il existe le risque de détruire la batterie 14 ou de provoquer un incendie si la batterie est défectueuse.

Aussi, l'invention met en oeuvre un diagnostic mis en oeuvre pendant toute la phase d'activation du mode série avec relais ouverts afin de vérifier que l'ouverture du relais a été correctement effectué.

Toutefois, la seule mesure de la différence de tension entre la tension aux bornes de la batterie 14 et la tension aux bornes de la capacité 13 du bus DC 12 n'est pas suffisante, car il se peut que ces deux tensions soient proches, que le relais 19 soit ouvert ou non.

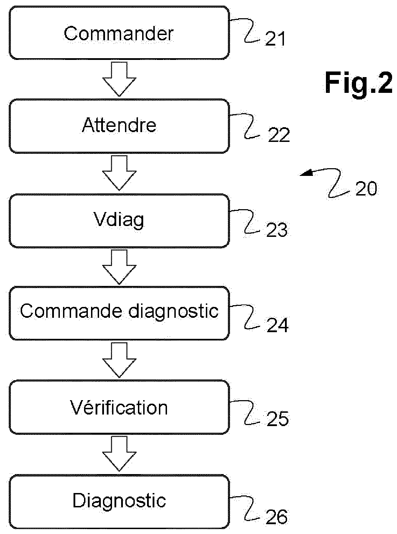

Aussi, en référence à la figure 2, on met en oeuvre un procédé de diagnostic 20 comprenant en premier lieu la mise en oeuvre d'une étape de commande 21 de l'ouverture du relais 19.

De manière avantageuse, on procède alors à une étape d'attente 22 au cours de laquelle le procédé attend une durée 35 correspondant sensiblement au temps maximal d'ouverture du relais 19. Ce délai est donc déterminé en fonction des spécifications techniques du relais 19 mis en oeuvre.

En parallèle de l'attente, ou selon des alternatives équivalentes, avant ou après cette étape d'attente 22, on procède aussi à la définition 23 d'une fonction de tension de consigne de diagnostic Vdiag du bus de tension continue 12.

Une telle fonction temporelle de tension de diagnostic variable Vdiag comprend une tension de consigne Vcons, correspondant à la tension souhaitée sur le bus DC 12, à laquelle on ajoute une composante variable.

La composante variable vise à faire varier la tension initiale de consigne sur le bus DC 12 afin de vérifier que la tension fournie effectivement par le second onduleur 17, associé à la seconde machine électrique 16, correspond bien à une tension de consigne modifiée dite tension de diagnostic variable.

Le diagnostic selon le procédé 20 est donc mis en oeuvre sur la commande de régulation en tension de l'onduleur 17.

En effet, si la tension régulée V_{DC} ne converge pas vers la tension de consigne Vcons, cela signifie que le relais 19 n'est pas correctement fermé. Or comme nous l'exposions précédemment, il peut arriver que la tension de consigne étant parfois la même que la tension aux bornes de la batterie 14, la seule comparaison des deux ne permet pas de déterminer formellement la fermeture du relais 19.

Aussi, la composante variable de la tension de consigne vise à faire varier cette tension de consigne selon plusieurs critères, définis dans ce mode de réalisation, mais de manière non limitative :
Tout d'abord on définit la composante variable, telle qu'une composante triangulaire ou trapézoïdale, comme devant être compatible avec la dynamique de la régulation de tension, afin que celle-ci arrive à bien suivre la consigne et ne génère pas de dépassement / Sous-dépassement, mieux connus sous le nom d*'overshoot*/*undershoot* en conditions nominales. Par conséquent on définit la pente maximale de la composante variable, inférieure à un seuil qui correspond à la capacité de réponse dynamique de la régulation de tension. Et on définit la pente minimale de cette composante variable à partir des seuils d'éloignement en amplitude 32, 33 et du temps maximal autorisé pour détecter et stopper le mode série avant apparition du risque feu.

Ensuite on souhaite que la période de la composante variable soit inférieure à 1 seconde. Cette contrainte est liée à des impératifs de sécurité qui peuvent varier en fonction des besoins. Dans cet exemple de mise en oeuvre, il est souhaité, au titre d'une contrainte de sécurité de la batterie, de détecter une fermeture intempestive du relais 19 en moins d'une seconde.

Par ailleurs on souhaite que la composante variable puisse s'écarter en amplitude suffisamment de la tension de consigne Vcons pour couvrir les cas où la tension batterie est égale à la tension de consigne. Aussi, la composante variable doit être contrôlée par une valeur déterminée en amplitude, cette valeur étant, pour sa définition, fonction de la valeur de consigne.

Enfin, il faut tout de même que l'amplitude de la tension variable reste une tension, une fois additionnée à la tension de consigne Vcons, tolérable par les équipements haute tension connectés au bus DC 12.

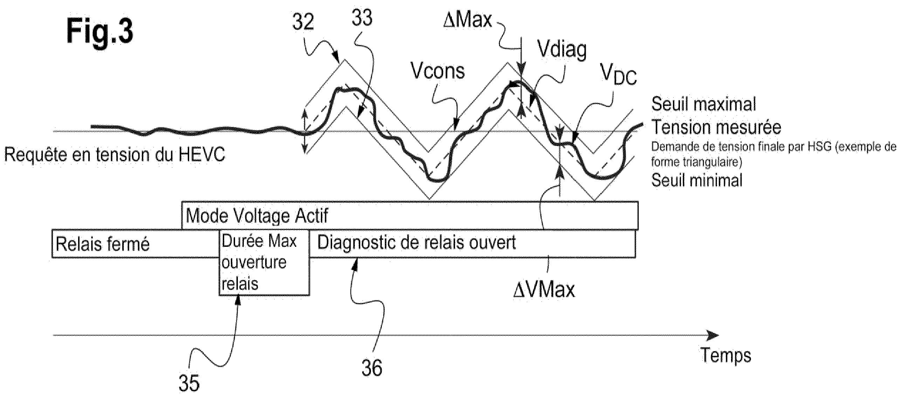

A cet égard on définit dans cet exemple de réalisation un profil triangulaire tel qu'il est représenté en figure 3. Toutefois l'invention n'est pas limitée seulement au motif triangulaire de la composante variable périodique. On peut aussi prévoir tout type de signal périodique tel qu'un signal sinusoïdal, un signal en créneau, ou encore un profil trapézoïdal.

En particulier la composante trapézoïdale est particulièrement pertinente en ce qu'elle permet un compromis optimisé entre le temps de détection, sa simplicité d'implémentation et la perturbation réseau provoquée.

On met aussi en oeuvre une étape de définition d'une amplitude de seuil d'éloignement (ΔVmax) maximal de la tension de diagnostic variable (Vdiag).

Cette amplitude d'éloignement est représentée sur les figures 3-5 sous forme de fonctions de seuils d'éloignement en amplitude 32, 33, correspondant à des fonctions identiques à la fonction de tension de diagnostic variable Vdiag décalée l'une d'une constante positive, dite offset de seuil positif, et l'autre d'une constante négative, dite offset de seuil négatif, de sorte à former une enveloppe autour la fonction de diagnostic. Les deux offsets de seuil, positifs et négatifs, étant ici d'une même valeur absolue,

L'invention n'est pas limitée à ce cas où le seuil supérieur est égal au seuil inférieur, et l'homme du métier pourrait adapter l'invention de sorte à ce que les deux offsets, positif et négatif, aient des valeurs absolues différentes.

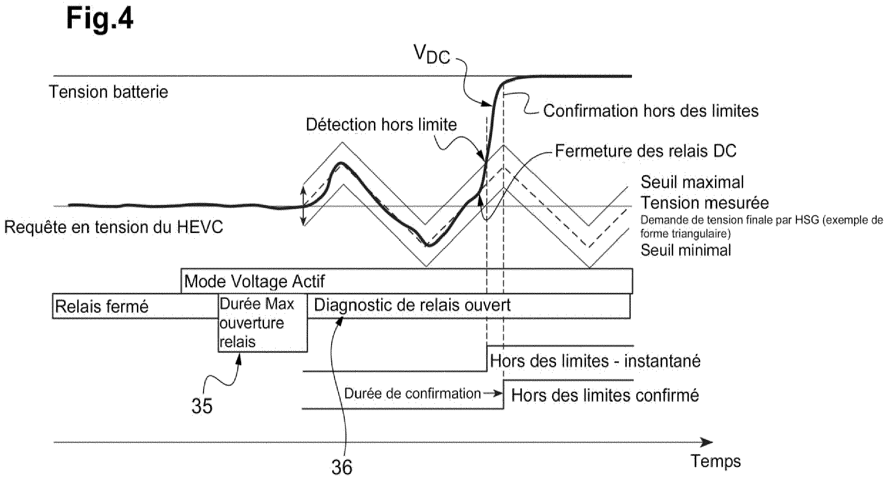

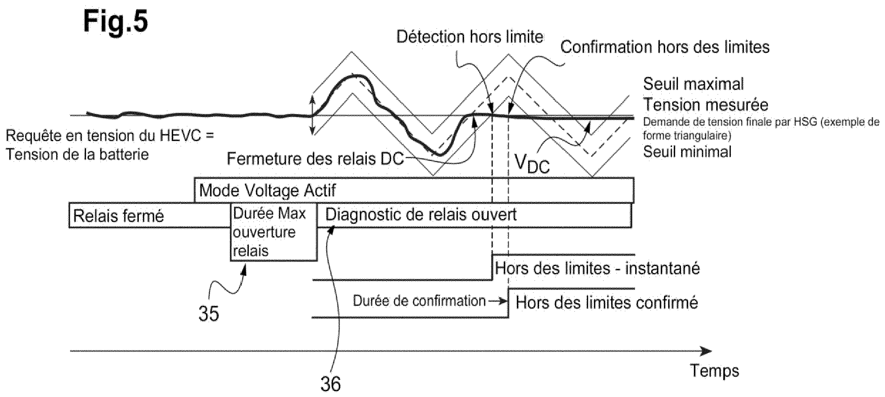

Autrement dit ces deux fonctions de seuils 32, 33, représentant visuellement l'amplitude d'éloignement ΔVmax maximal de la tension de diagnostic variable, constituent des seuils d'extrémité, entre lesquels la tension régulée V_{DC} est considérée comme suivant correctement la consigne, tel que représenté figure 3, et hors desquels, tel que représenté figure 4 ou 5, on considère que la tension régulée ne suit plus la tension de diagnostic variable.

Une fois que la tension de diagnostic variable Vdiag est définie et après que l'étape d'attente 22 soit terminée, on met alors en oeuvre une étape de commande (24) de régulation de la tension sur le bus DC 12 au second onduleur 17, afin de faire réguler la tension à la capacité 13 du bus DC 12 à la tension de diagnostic Vdiag variable.

Cette tension de diagnostic variable Vdiag étant une tension variable, la tension régulée V_{DC} doit suivre le profil de la tension de diagnostic variable Vdiag, sur toute la période 36 de diagnostic.

Dans cet exemple de réalisation, la période du signal est inférieure à 1 seconde. Le diagnostique est effectué en continu, par exemple avec une exécution toutes les 10ms.

Au cours de cette période de diagnostic 36, ou après cette période de diagnostic 36 selon une alternative de mise en oeuvre, on procède à une étape de vérification 25, au cours de laquelle on vérifie, si au cours de la période de diagnostic 36 la tension V_{DC} du bus de tension continue a toujours suivi, sur une fenêtre glissante d'une durée prédéfinie, la tension de diagnostic variable Vdiag avec un écart inférieur à l'amplitude de seuil ΔVmax définie.

En particulier la période de diagnostic 36 est une durée prédéfinie d'une fenêtre glissante.

Dit autrement, on vérifie que la tension V_{DC} soit restée au cours de la période de diagnostic 36 dans les limites des deux fonctions de seuils d'éloignement en amplitude 32, 33.

Aussi, si sur la période de diagnostic 36, la tension du bus de tension continue V_{DC} a suivi la tension de diagnostic variable Vdiag avec un écart inférieur ou égal à l'amplitude de seuil définie, diagnostiquer que ledit relais est ouvert ; et

Aussi, si sur la durée prédéfinie la tension du bus de tension continue V_{DC} a suivi la tension de diagnostic variable Vdiag avec un écart inférieur ou égal à l'amplitude de seuil définie, on diagnostique 26 que le relais 19 est correctement ouvert. On peut alors dans ce cas, continuer le fonctionnement en mode série.

Ici, le diagnostic s'effectue en continu tant que le mode série est activé.
Le même procédé permet aussi de faire le diagnostic de la bonne ouverture des relais juste après leur ouverture, mais aussi de détecter des refermetures intempestives tout au long du fonctionnement du mode série.

Par contre, si au cours de la durée prédéfinie de diagnostic 36 la tension du bus de tension V_{DC} s'est écartée de la tension de diagnostic variable Vdiag d'un écart supérieur à l'amplitude de seuil définie, tel que représenté figures 4 et 5, on diagnostique alors que le relais 19 n'est pas correctement ouvert. On procède alors, selon les régulations de sécurité souhaitées soit à un arrêt électrique, soit à une mesure de sauvegarde visant à correctement isoler la batterie 14.

Toutefois selon une mise en oeuvre particulière de l'invention, afin d'éviter qu'une déviation transitoire ne déclenche un diagnostic incorrect, on définit une durée de confirmation du diagnostic, par exemple 250ms, ou une valeur comprise entre 10ms et 1 seconde.

Ainsi, si la tension continue est hors des limites établies pendant une durée inférieure à cette durée de confirmation, on considère alors qu'il ne s'agit pas d'un écart significatif, mais si la tension continue est hors des limites établies pendant une durée supérieure ou égale à cette durée de confirmation, on considère alors qu'il s'agit d'un écart significatif et d'un relais incorrectement ouvert.

Ce procédé de diagnostic, ainsi adapté à un groupe motopropulseur peut être adapté à tout type de réseau électrique triphasé utilisé en mode régulation d'un bus DC avec une faible capacité, ou sur réseau de type *smart grid*, qui peut être déconnecté d'un système haute tension et dont la valeur de tension nominale peut varier sur une grande plage de fonctionnement.

## Revendications

1. Procédé de diagnostic d'un groupe motopropulseur hybride (1) d'un véhicule automobile, comprenant une première machine électrique (10) d'entraînement du véhicule automobile, connectée via un premier onduleur (15) à un bus de tension continue (12) lissé en tension par un organe d'amortissement passif (13),
le groupe motopropulseur hybride (1) comprenant en outre une seconde machine électrique (16) apte à recevoir l'énergie produite par une machine à combustion interne (18) et à la transmettre audit bus de tension continue (12), un second onduleur (17) connecté entre ladite seconde machine électrique (16) et ledit bus de tension continue (12) régulant la tension dudit bus de tension continue (12) ; et une batterie d'accumulateurs électrique (14) connectée au bus de tension continue (12) par un relais commandé (19), pour fournir une tension continue (V_{DC}) audit bus de tension continue (12) ; le véhicule automobile comprenant un organe de commande du groupe motopropulseur (1) adapté pour mettre en oeuvre les étapes suivantes :
- Commander (21) l'ouverture dudit relais commandé (19) de sorte à isoler la batterie (14) du bus de tension continue ;
- Définir (22) une fonction de tension de diagnostic variable (Vdiag) en fonction d'une tension de consigne (Vcons) du bus de tension continue (12) et d'une composante variable périodique ;
- Définir (23) une amplitude de seuil d'éloignement (ΔVmax) de la tension de diagnostic variable (Vdiag) ;
- Commander (24) audit second onduleur (17) la régulation du bus de tension continue (12) à ladite tension de diagnostic variable (Vdiag) ;
- Vérifier (25), sur une fenêtre glissante d'une durée prédéfinie, si la tension (V_{DC}) du bus de tension continue suit la tension de diagnostic variable (Vdiag) avec un écart inférieur à l'amplitude de seuil (ΔVmax) définie ;
- Diagnostiquer (26) l'ouverture du relais en fonction des conditions suivantes :
∘ Si sur la durée prédéfinie de ladite fenêtre glissante la tension du bus de tension continue a suivi la tension de diagnostic variable (Vdiag) avec un écart inférieur ou égal à l'amplitude de seuil définie, diagnostiquer que ledit relais (19) est ouvert ; et
∘ Si au cours de la durée prédéfinie de ladite fenêtre glissante, la tension du bus de tension s'est écartée de la tension de diagnostic variable (Vdiag) d'un écart supérieur à l'amplitude de seuil définie, diagnostiquer que ledit relais (19) n'est pas correctement ouvert.

2. Procédé selon la revendication 1 dans lequel on procède, après l'étape de commande (21) d'ouverture dudit relais (19), à une étape d'attente (22) d'une durée prédéterminée (35), avant de mettre en oeuvre l'étape de commande audit second onduleur (17).

3. Procédé selon la revendication 1 ou 2, **caractérisé en ce qu'**au cours de l'étape de diagnostic, on diagnostique que ledit relais (19) n'est pas correctement ouvert si, sur la durée prédéfinie la tension du bus de tension s'est écartée de la tension de diagnostic variable (Vdiag) d'un écart supérieur à l'amplitude de seuil définie, de manière continue pendant une durée de confirmation prédéterminée.

4. Procédé selon l'une quelconque des revendications 1 à 3, **caractérisé en ce que** ladite composante variable périodique de ladite tension de diagnostic variable (Vdiag) comprend une composante triangulaire ou trapézoïdale ajoutée à ladite tension de consigne (Vcons).

5. Dispositif de diagnostic d'un groupe motopropulseur hybride (1) d'un véhicule automobile, le véhicule automobile comprenant une première machine électrique (10) d'entraînement du véhicule automobile, connectée via un premier onduleur (15) à un bus de tension continue (12) lissé en tension par un organe d'amortissement passif (13),
le groupe motopropulseur hybride (1) comprenant en outre une seconde machine électrique (16) apte à recevoir l'énergie produite par une machine à combustion interne (18) et à la transmettre audit bus de tension continue (12), un second onduleur (17) connecté entre ladite seconde machine électrique (16) et ledit bus de tension continue (12) régulant en tension ledit bus de tension continue (12) ; et une batterie d'accumulateurs électrique (14) connecté au bus de tension continue (12) par un relais commandé (19), pour fournir une tension continue audit bus de tension continue (12), ledit dispositif comprenant :
- Des moyens de commande de l'ouverture dudit relais commandé (19) de sorte à isoler la batterie (14) du bus de tension continue ;
- Des moyens de définition d'une fonction de tension de diagnostic variable (Vdiag) en fonction d'une tension de consigne (Vcons) du bus de tension continue (12) et d'une composante variable périodique ;
- Des moyens de définition d'une amplitude de seuil d'éloignement (ΔVmax) de la tension de diagnostic variable (Vdiag) ;
- Des moyens de commande dudit second onduleur (17) pour réguler le bus de tension continue (12) à ladite tension de diagnostic variable (Vdiag) ;
- Des moyens de vérification, sur une fenêtre glissante d'une durée prédéfinie, si la tension (V_{DC}) du bus de tension continue suit la tension de diagnostic variable (Vdiag) avec un écart inférieur à l'amplitude de seuil (ΔVmax) définie ;
- Des moyens de diagnostics adaptés pour diagnostiquer l'ouverture du relais (19) en fonction des conditions suivantes : si sur la durée prédéfinie de ladite fenêtre glissante, la tension du bus de tension continue a suivi la tension de diagnostic variable (Vdiag) avec un écart inférieur ou égal à l'amplitude de seuil définie, on diagnostique que ledit relais (19) est ouvert ; et si au cours de la durée prédéfinie la tension du bus de tension s'est écartée de la tension de diagnostic variable (Vdiag) d'un écart supérieur à l'amplitude de seuil définie, on diagnostique que ledit relais (19) n'est pas correctement ouvert.

6. Véhicule automobile comprenant un groupe motopropulseur hybride (1) d'un véhicule automobile, comprenant une première machine électrique (10) d'entraînement du véhicule automobile, connectée via un premier onduleur (15) à un bus de tension continue (12) lissé en tension par un organe d'amortissement passif (condensateur) (13), le groupe motopropulseur hybride (1) comprenant en outre une seconde machine électrique (16) apte à recevoir l'énergie produite par une machine à combustion interne (18) et à la transmettre audit bus de tension continue (12), un second onduleur (17) connecté entre ladite seconde machine électrique (16) et ledit bus de tension continue (12) régulant en tension ledit bus de tension continue (12); et une batterie d'accumulateurs électrique (14) connecté au bus de tension continue (12) par un relais commandé (19), pour fournir une tension continue audit bus de tension continue (12), et un dispositif de diagnostic selon la revendication 5.

## Patentansprüche

1. Verfahren zur Diagnose eines Hybridantriebsstrangs (1) eines Kraftfahrzeugs, umfassend eine erste elektrische Maschine (10) zum Antreiben des Kraftfahrzeugs, die über einen ersten Wechselrichter (15) an einen Gleichspannungsbus (12) angeschlossen ist, dessen Spannung durch eine passive Dämpfungseinrichtung (13) geglättet wird,
wobei der Hybridantriebsstrang (1) ferner eine zweite elektrische Maschine (16) umfasst, die geeignet ist, die von einer Brennkraftmaschine (18) erzeugte Energie aufzunehmen und sie an den Gleichspannungsbus (12) zu übertragen, wobei ein zweiter Wechselrichter (17), der zwischen der zweiten elektrischen Maschine (16) und dem Gleichspannungsbus (12) angeschlossen ist, die Spannung des Gleichspannungsbusses (12) regelt; und eine elektrische Akkumulatorbatterie (14), die über ein gesteuertes Relais (19) an den Gleichspannungsbus (12) angeschlossen ist, um eine Gleichspannung (V_{DC}) an den Gleichspannungsbus (12) abzugeben; wobei das Kraftfahrzeug eine Steuereinrichtung des Antriebsstrangs (1) umfasst, die geeignet ist, die folgenden Schritte auszuführen:
- Steuern (21) des Öffnens des gesteuerten Relais (19), so dass die Batterie (14) von dem Gleichspannungsbus getrennt wird;
- Definieren (22) einer Funktion einer variablen Diagnosespannung (Vdiag) in Abhängigkeit von einer Sollspannung (Vcons) des Gleichspannungsbusses (12) und von einer periodischen variablen Komponente;
- Definieren (23) einer Entfernungsschwellenamplitude (ΔVmax) der variablen Diagnosespannung (Vdiag);
- Steuern (24) des zweiten Wechselrichters (17) zur Regelung des Gleichspannungsbusses (12) auf die variable Diagnosespannung (Vdiag);
- Überprüfen (25), über ein gleitendes Fenster mit einer vorgegebenen Dauer, ob die Spannung (V_{DC}) des Gleichspannungsbusses der variablen Diagnosespannung (Vdiag) mit einer Abweichung folgt, die kleiner als die definierte Schwellenamplitude (ΔVmax) ist;
- Diagnostizieren (26) der Öffnung des Relais in Abhängigkeit von den folgenden Bedingungen:
∘ Wenn über die vorgegebene Dauer des gleitenden Fensters die Spannung des Gleichspannungsbusses der variablen Diagnosespannung (Vdiag) mit einer Abweichung gefolgt ist, die kleiner oder gleich der definierten Schwellenamplitude ist, diagnostizieren, dass das Relais (19) geöffnet ist; und
∘ Wenn während der vorgegebenen Dauer des gleitenden Fensters die Spannung des Spannungsbusses von der variablen Diagnosespannung (Vdiag) um eine Abweichung abgewichen ist, die größer als die definierte Schwellenamplitude ist, diagnostizieren, dass das Relais (19) nicht ordnungsgemäß geöffnet ist.

2. Verfahren nach Anspruch 1, bei dem, nach dem Schritt des Steuerns (21) des Öffnens des Relais (19), ein Schritt des Wartens (22) einer vorbestimmten Dauer (35) vorgenommen wird, bevor der Schritt des Steuerns des zweiten Wechselrichters (17) ausgeführt wird.

3. Verfahren nach Anspruch 1 oder 2, **dadurch gekennzeichnet, dass** während des Diagnoseschritts diagnostiziert wird, dass das Relais (19) nicht ordnungsgemäß geöffnet ist, wenn über die vorgegebene Dauer die Spannung des Spannungsbusses von der variablen Diagnosespannung (Vdiag) um eine Abweichung, die größer als die definierte Schwellenamplitude ist, kontinuierlich während einer vorbestimmten Bestätigungsdauer abgewichen ist.

4. Verfahren nach einem der Ansprüche 1 bis 3, **dadurch gekennzeichnet, dass** die periodische variable Komponente der variablen Diagnosespannung (Vdiag) eine dreieckige oder trapezförmige Komponente umfasst, die zu der Sollspannung (Vcons) hinzugefügt wird.

5. Vorrichtung zur Diagnose eines Hybridantriebsstrangs (1) eines Kraftfahrzeugs, wobei das Kraftfahrzeug eine erste elektrische Maschine (10) zum Antreiben des Kraftfahrzeugs umfasst, die über einen ersten Wechselrichter (15) an einen Gleichspannungsbus (12) angeschlossen ist, dessen Spannung durch eine passive Dämpfungseinrichtung (13) geglättet wird,
wobei der Hybridantriebsstrang (1) ferner eine zweite elektrische Maschine (16) umfasst, die geeignet ist, die von einer Brennkraftmaschine (18) erzeugte Energie aufzunehmen und sie an den Gleichspannungsbus (12) zu übertragen, wobei ein zweiter Wechselrichter (17), der zwischen der zweiten elektrischen Maschine (16) und dem Gleichspannungsbus (12) angeschlossen ist, die Spannung des Gleichspannungsbusses (12) regelt; und eine elektrische Akkumulatorbatterie (14), die über ein gesteuertes Relais (19) an den Gleichspannungsbus (12) angeschlossen ist, um eine Gleichspannung an den Gleichspannungsbus (12) abzugeben; wobei die Vorrichtung umfasst:
- Mittel zum Steuern des Öffnens des gesteuerten Relais (19), so dass die Batterie (14) von dem Gleichspannungsbus getrennt wird;
- Mittel zum Definieren einer Funktion einer variablen Diagnosespannung (Vdiag) in Abhängigkeit von einer Sollspannung (Vcons) des Gleichspannungsbusses (12) und von einer periodischen variablen Komponente;
- Mittel zum Definieren einer Entfernungsschwellenamplitude (ΔVmax) der variablen Diagnosespannung (Vdiag);
- Mittel zum Steuern des zweiten Wechselrichters (17), um den Gleichspannungsbus (12) auf die variable Diagnosespannung (Vdiag) zu regeln;
- Mittel zum Überprüfen, über ein gleitendes Fenster mit einer vorgegebenen Dauer, ob die Spannung (V_{DC}) des Gleichspannungsbusses der variablen Diagnosespannung (Vdiag) mit einer Abweichung folgt, die kleiner als die definierte Schwellenamplitude (ΔVmax) ist;
- Diagnosemittel, die geeignet sind, das Öffnen des Relais (19) in Abhängigkeit von den folgenden Bedingungen zu diagnostizieren: Wenn über die vorgegebene Dauer des gleitenden Fensters die Spannung des Gleichspannungsbusses der variablen Diagnosespannung (Vdiag) mit einer Abweichung gefolgt ist, die kleiner oder gleich der definierten Schwellenamplitude ist, wird diagnostiziert, dass das Relais (19) geöffnet ist; und wenn während der vorgegebenen Dauer die Spannung des Spannungsbusses von der variablen Diagnosespannung (Vdiag) um eine Abweichung abgewichen ist, die größer als die definierte Schwellenamplitude ist, wird diagnostiziert, dass das Relais (19) nicht ordnungsgemäß geöffnet ist.

6. Kraftfahrzeug, umfassend einen Hybridantriebsstrang (1) eines Kraftfahrzeugs, umfassend eine erste elektrische Maschine (10) zum Antreiben des Kraftfahrzeugs, die über einen ersten Wechselrichter (15) an einen Gleichspannungsbus (12) angeschlossen ist, dessen Spannung durch eine passive Dämpfungseinrichtung (Kondensator) (13) geglättet wird, wobei der Hybridantriebsstrang (1) ferner eine zweite elektrische Maschine (16) umfasst, die geeignet ist, die von einer Brennkraftmaschine (18) erzeugte Energie aufzunehmen und sie an den Gleichspannungsbus (12) zu übertragen, wobei ein zweiter Wechselrichter (17), der zwischen der zweiten elektrischen Maschine (16) und dem Gleichspannungsbus (12) angeschlossen ist, die Spannung des Gleichspannungsbusses (12) regelt; und eine elektrische Akkumulatorbatterie (14), die über ein gesteuertes Relais (19) an den Gleichspannungsbus (12) angeschlossen ist, um eine Gleichspannung an den Gleichspannungsbus (12) abzugeben, und eine Diagnosevorrichtung nach Anspruch 5.

## Claims

1. Method for diagnosing a hybrid powertrain (1) of a motor vehicle, comprising a first electric machine (10) for driving the motor vehicle, which first electric machine is connected via a first inverter (15) to a DC voltage bus (12) the voltage of which is smoothed by a passive damping element (13),
the hybrid powertrain (1) further comprising a second electric machine (16) that is able to receive the energy produced by an internal combustion engine (18) and to transmit it to said DC voltage bus (12), a second inverter (17), which is connected between said second electric machine (16) and said DC voltage bus (12), regulating the voltage of said DC voltage bus (12); and an electric storage battery (14) connected to the DC voltage bus (12) by a commanded relay (19) so as to supply a DC voltage (V_{DC}) to said DC voltage bus (12); the motor vehicle comprising a control element for controlling the powertrain (1), which control element is designed to implement the following steps:
- Commanding (21) the opening of said commanded relay (19) so as to isolate the battery (14) from the DC voltage bus;
- Defining (22) a variable diagnostic voltage function (Vdiag) as a function of a setpoint voltage (Vcons) of the DC voltage bus (12) and of a periodic variable component;
- Defining (23) a distance threshold amplitude (ΔVmax) of the variable diagnostic voltage (Vdiag);
- Commanding (24) said second inverter (17) to regulate the DC voltage bus (12) to said variable diagnostic voltage (Vdiag);
- Checking (25), over a sliding window of a predefined duration, whether the voltage (V_{DC}) of the DC voltage bus follows the variable diagnostic voltage (Vdiag) with a deviation less than the defined threshold amplitude (ΔVmax);
- Diagnosing (26) the opening of the relay according to the following conditions:
∘ If, over the predefined duration of said sliding window, the voltage of the DC voltage bus has followed the variable diagnostic voltage (Vdiag) with a deviation less than or equal to the defined threshold amplitude, diagnose that said relay (19) is open; and
∘ If, during the predefined duration of said sliding window, the voltage of the voltage bus has deviated from the variable diagnostic voltage (Vdiag) with a deviation greater than the defined threshold amplitude, diagnose that said relay (19) is not correctly opened.

2. Method according to Claim 1, wherein, after the step of commanding (21) the opening of said relay (19), a step of waiting (22) for a predetermined duration (35) is carried out before implementing the step of commanding said second inverter (17).

3. Method according to Claim 1 or 2, **characterized in that**, during the diagnosing step, it is diagnosed that said relay (19) is not correctly opened if, over the predefined duration, the voltage of the voltage bus has deviated from the variable diagnostic voltage (Vdiag) with a deviation greater than the defined threshold amplitude continuously for a predetermined confirmation duration.

4. Method according to any one of Claims 1 to 3, **characterized in that** said periodic variable component of said variable diagnostic voltage (Vdiag) comprises a triangular or trapezoidal component added to said setpoint voltage (Vcons).

5. Device for diagnosing a hybrid powertrain (1) of a motor vehicle, the motor vehicle comprising a first electric machine (10) for driving the motor vehicle, which first electric machine is connected via a first inverter (15) to a DC voltage bus (12) the voltage of which is smoothed by a passive damping element (13),
the hybrid powertrain (1) further comprising a second electric machine (16) that is able to receive the energy produced by an internal combustion engine (18) and to transmit it to said DC voltage bus (12), a second inverter (17), which is connected between said second electric machine (16) and said DC voltage bus (12), regulating the voltage of said DC voltage bus (12); and an electric storage battery (14) connected to the DC voltage bus (12) by a commanded relay (19) so as to supply a DC voltage to said DC voltage bus (12), said device comprising:
- Means for commanding the opening of said commanded relay (19) so as to isolate the battery (14) from the DC voltage bus;
- Means for defining a variable diagnostic voltage function (Vdiag) as a function of a setpoint voltage (Vcons) of the DC voltage bus (12) and of a periodic variable component;
- Means for defining a distance threshold amplitude (ΔVmax) of the variable diagnostic voltage (Vdiag);
- Means for commanding said second inverter (17) to regulate the DC voltage bus (12) to said variable diagnostic voltage (Vdiag);
- Means for checking, over a sliding window of a predefined duration, whether the voltage (V_{DC}) of the DC voltage bus follows the variable diagnostic voltage (Vdiag) with a deviation less than the defined threshold amplitude (ΔVmax);
- Diagnosis means designed to diagnose the opening of the relay (19) according to the following conditions: if, over the predefined duration of said sliding window, the voltage of the DC voltage bus has followed the variable diagnostic voltage (Vdiag) with a deviation less than or equal to the defined threshold amplitude, it is diagnosed that said relay (19) is open; and if, during the predefined duration, the voltage of the voltage bus has deviated from the variable diagnostic voltage (Vdiag) with a deviation greater than the defined threshold amplitude, it is diagnosed that said relay (19) is not correctly opened.

6. Motor vehicle comprising a hybrid powertrain (1) of a motor vehicle, comprising a first electric machine (10) for driving the motor vehicle, which first electric machine is connected via a first inverter (15) to a DC voltage bus (12) the voltage of which is smoothed by a passive damping element (capacitor) (13), the hybrid powertrain (1) further comprising a second electric machine (16) that is able to receive the energy produced by an internal combustion engine (18) and to transmit it to said DC voltage bus (12), a second inverter (17), which is connected between said second electric machine (16) and said DC voltage bus (12), regulating the voltage of said DC voltage bus (12); and an electric storage battery (14) connected to the DC voltage bus (12) by a commanded relay (19) so as to supply a DC voltage to said DC voltage bus (12), and a diagnosis device according to Claim 5.
